# EUROPEAN PATENT APPLICATION

(11) **EP 4 744 890 A1**
(43) Date of publication of application: **20.05.2026**
(21) Application number: 24839686.3
(22) Date of filing: 05.07.2024
(51) Int. Cl.: B32B 27/00, B32B 15/08, H05K 3/46

(54) **ADHESIVE LAMINATE SHEET, LAMINATE, AND METHOD FOR MANUFACTURING WIRING BOARD**

(30) Priority: 13.07.2023 JP 2023115310
(71) Applicant: Mitsui Kinzoku Company, Limited, Tokyo 141-8584 (JP)
(72) Inventor: KITABATAKE, Yukiko, Ageo-shi, Saitama 362-0021 (JP); KUWAHARA, Kyohei, Ageo-shi, Saitama 362-0021 (JP); NAKAMURA, Toshimi, Ageo-shi, Saitama 362-0021 (JP); MATSUURA, Yoshinori, Ageo-shi, Saitama 362-0021 (JP)
(74) Representative: Potter Clarkson
(86) International application number: PCT/JP2024/024479
(87) International publication number: WO 2025/013794

(57) **Abstract**

There is provided an adhesive laminate sheet that allows for rapid release and removal after use as a reinforcing sheet. The adhesive laminate sheet includes a carrier, a release layer provided on the carrier, and an adhesive layer provided on the release layer and containing an adhesive material.

## Description

### TECHNICAL FIELD

The present invention relates to an adhesive laminate sheet, a laminate, and a method for manufacturing a wiring board.

### BACKGROUND ART

In recent years, multilayering of printed wiring boards has become widespread to increase the mounting density of the printed wiring boards for size reduction. Such multilayer printed wiring boards have been in use in many portable electronic apparatuses to reduce weight and size. These multilayer printed wiring boards have been required to have further reductions in the thicknesses of interlayer insulating layers and to still further weight reductions as wiring boards.

As a technique for satisfying such requirements, a method for manufacturing a multilayer printed wiring board using a coreless build-up method has been adopted. The coreless build-up method is a method of alternately laminating (building up) insulating layers and wiring layers for multilayering, without using a so-called core substrate. For the coreless build-up method, using a carrier-attached copper foil has been proposed to enable easy release of a support and a multilayer printed wiring board from each other. For example, Patent Literature 1 (JP2005-101137A) discloses a method for manufacturing a package substrate for semiconductor device mounting, the method including affixing an insulating resin layer to the carrier surface of a carrier-attached copper foil to form a support, forming a first wiring conductor on the superthin copper layer side of the carrier-attached copper foil by steps such as photoresist processing, pattern electrolytic copper plating, and resist removal, then forming build-up wiring layers, releasing the carrier-attached supporting substrate, and removing the superthin copper layer.

For the fining of an embedded circuit as shown in Patent Literature 1, a carrier-attached copper foil in which the thickness of a superthin copper layer is 1 µm or less is desired. Therefore, it has been proposed to use a vapor phase method, such as sputtering, to form a superthin copper layer and achieve a reduction in the thickness of the superthin copper layer. For example, Patent Literature 2 (WO2017/150283) discloses a carrier-attached copper foil in which a release layer, an antireflection layer, and a superthin copper layer are formed on a carrier such as glass or ceramic by sputtering. Patent Literature 3 (WO2017/150284) discloses a carrier-attached copper foil in which intermediate layers (for example, an adhesion metal layer and a release-assisting layer), a release layer, and a superthin copper layer (for example, a film thickness of 300 nm) are formed on a carrier such as glass or ceramic by sputtering. Patent Literatures 2 and 3 also teach that intermediate layers composed of predetermined metals are interposed, thus providing excellent stability of the mechanical release strength of the carrier, and that the antireflection layer exhibits a desirable dark color, thus improving visibility in image inspection (for example, automatic image inspection (AOI)).

Especially, with still further size reduction and power saving of electronic devices, there is a growing need for the high integration and thinning of semiconductor chips and printed wiring boards. As next-generation packaging techniques for satisfying such a need, the adoption of fan-out wafer level packaging (FO-WLP) and panel level packaging (PLP) has been studied in recent years. The adoption of the coreless build-up method has also been studied for FO-WLP and PLP. One such method is a method referred to as a redistribution layer-first (RDL-first) method in which a wiring layer and, if necessary, a build-up wiring layer are formed on a coreless support surface, and, if necessary, the support is released, followed by mounting of chips. For example, Patent Literature 4 (JP2015-35551A) discloses a method for manufacturing a semiconductor apparatus, the method including forming a metal release layer on the main surface of a support composed of glass or a silicon wafer, forming an insulating resin layer on the metal release layer, forming a redistribution layer including build-up layers on the insulating resin layer, mounting and sealing semiconductor integrated circuits on the redistribution layer, exposing the release layer by the removal of the support, exposing secondary mounting pads by the removal of the release layer, and forming solder bumps on the surfaces of the secondary mounting pads, and performing secondary mounting.

In recent technological trends, the adoption of FO-WLP and PLP has been studied, and there is a demand for thinning of the build-up layers. However, in the case where the build-up layers are thin, during the release of the substrate from the build-up layer-attached substrate prepared using a coreless build-up method, the build-up layers may bend locally and greatly. Such great bending of the build-up layers can cause disconnection or delamination of wiring layers inside the build-up layers, which may result in a decrease in the connection reliability of the wiring layers. In order to address such a problem, it has been proposed to laminate a reinforcing sheet onto the multilayer laminate to improve handleability. For example, Patent Literature 5 (JP6731060B) discloses, in the manufacture of a multilayer wiring board, laminating a reinforcing sheet onto a multilayer wiring layer-attached laminate including a releasable substrate via a second release layer that provides a predetermined release strength. According to such a method, the substrate and the reinforcing sheet can be released in this order without causing the multilayer wiring layers to be bent locally and greatly. Patent Literature 6 (JP6731061B) discloses laminating a reinforcing sheet having a Vickers hardness lower than that of the substrate onto a multilayer wiring layer-attached laminate including a releasable substrate, in order to improve the connection reliability of the multilayer wiring layers and the flatness of the multilayer wiring layer surface. Patent Literature 7 (JP7112962B) discloses providing an opening in a reinforcing sheet and using a soluble adhesive layer for laminating the reinforcing sheet onto a multilayer laminate. Patent Literature 8 (JP7208011B) discloses using a soluble adhesive layer for laminating a reinforcing sheet onto a multilayer laminate, and providing a non-occupied region in which the soluble adhesive layer is not formed within a predetermined region. According to the methods disclosed in Patent Literatures 7 and 8, it is said that release of the reinforcing sheet that has served its purpose can be carried out in an extremely short time by dissolution release or other methods, while minimizing stress applied to the multilayer laminate.

### CITATION LIST

### PATENT LITERATURE

Patent Literature 1: JP2005-101137A
Patent Literature 2: WO2017/150283
Patent Literature 3: WO2017/150284
Patent Literature 4: JP2015-35551A
Patent Literature 5: JP6731060B
Patent Literature 6: JP6731061B
Patent Literature 7: JP7112962B
Patent Literature 8: JP7208011B

### SUMMARY OF INVENTION

In the case where the reinforcing sheets disclosed in Patent Literatures 7 and 8 are laminated onto a multilayer laminate, release of the reinforcing sheets that have served their purpose can be carried out in a short time. However, an even faster release of the reinforcing sheets is desired.

The present inventors have now found that, in an adhesive laminate sheet, by providing a release layer and an adhesive layer containing an adhesive material on a carrier in this order, rapid release and removal after use as a reinforcing sheet can be carried out.

Accordingly, an object of the present invention is to provide an adhesive laminate sheet that allows for rapid release and removal after use as a reinforcing sheet.

The present invention provides the following aspects:

### [Aspect 1]

An adhesive laminate sheet comprising:
a carrier;
a release layer provided on the carrier; and
an adhesive layer provided on the release layer and containing an adhesive material.

### [Aspect 2]

The adhesive laminate sheet according to aspect 1, further comprising a metal layer provided between the release layer and the adhesive layer.

### [Aspect 3]

The adhesive laminate sheet according to aspect 1 or 2, wherein the carrier is composed of a metal.

### [Aspect 4]

The adhesive laminate sheet according to any one of aspects 1 to 3, wherein the carrier is composed of at least one selected from the group consisting of aluminum, stainless steel, copper, titanium, nickel, and duralumin.

### [Aspect 5]

The adhesive laminate sheet according to any one of aspects 1 to 4, wherein the adhesive material is at least one selected from the group consisting of a thermosetting epoxy resin, a thermosetting polyimide resin, a photosensitive polyimide resin, an acrylic resin, and a phenolic resin.

### [Aspect 6]

The adhesive laminate sheet according to any one of aspects 1 to 5, wherein the adhesive layer has a thickness of 1 µm or more and 2000 µm or less.

### [Aspect 7]

The adhesive laminate sheet according to aspect 1 or 2, wherein a ratio of a plan view area of the adhesive layer A_{A} to a plan view area of the carrier A_{c}, A_{A}/A_{C}, is 0.03 or more and 1.0 or less.

### [Aspect 8]

The adhesive laminate sheet according to any one of aspects 2 to 7, wherein the metal layer is composed of at least one metal selected from the group consisting of Ti, Cu, Al, Nb, Zr, Cr, W, Ta, Co, Ag, Ni, In, Sn, Zn, Ga, and Mo.

### [Aspect 9]

The adhesive laminate sheet according to any one of aspects 2 to 8, wherein the metal layer has a thickness of 10 nm or more and 1000 nm or less.

### [Aspect 10]

The adhesive laminate sheet according to any one of aspects 1 to 9, wherein the release layer contains carbon.

### [Aspect 11]

A laminate comprising:
the adhesive laminate sheet according to any one of aspects 1 to 10;
a resin-containing layer provided on the adhesive layer of the adhesive laminate sheet; and
an additional metal layer provided on the resin-containing layer.

### [Aspect 12]

The laminate according to aspect 11, further comprising:
an additional release layer provided on the additional metal layer; and
an additional carrier provided on the additional release layer.

### [Aspect 13]

A method for manufacturing a wiring board, comprising the steps of:
providing a laminate including a first carrier, a first release layer, a first metal layer, and a resin-containing layer in this order;
laminating an adhesive laminate sheet onto the laminate, wherein the adhesive laminate sheet includes a second carrier, a second release layer, and an adhesive layer containing an adhesive material in this order, and the adhesive laminate sheet is laminated onto the laminate so that the adhesive layer comes into contact with the resin-containing layer;
releasing the first carrier from the laminate onto which the adhesive laminate sheet has been laminated via the first release layer;
releasing the second carrier from the laminate from which the first carrier has been released via the second release layer;
removing the second release layer from the laminate from which the second carrier has been released, thereby exposing the adhesive layer; and
removing the adhesive layer from the laminate from which the second release layer has been removed.

### [Aspect 14]

The method for manufacturing a wiring board according to aspect 13, wherein the adhesive laminate sheet further includes a second metal layer between the second release layer and the adhesive layer.

### [Aspect 15]

The method for manufacturing a wiring board according to aspect 13 or 14, wherein the resin-containing layer includes:
a first redistribution layer provided on the first metal layer;
a mold resin layer provided on the first redistribution layer; and
a second redistribution layer provided on the mold resin layer.

### [Aspect 16]

The method for manufacturing a wiring board according to aspect 15, wherein the mold resin layer contains an epoxy resin and/or a phenolic resin.

### [Aspect 17]

The method for manufacturing a wiring board according to any one of aspects 13 to 16, wherein release of the first carrier is carried out by a laser lift-off method or a mechanical method.

### [Aspect 18]

The method for manufacturing a wiring board according to any one of aspects 13 to 17, further comprising the step of heating the laminate at 100°C or higher and 350°C or lower after laminating the adhesive laminate sheet onto the laminate and before releasing the second carrier.

### [Aspect 19]

The method for manufacturing a wiring board according to any one of aspects 13 to 18,
wherein the method further comprises the step of, after releasing the first carrier from the laminate and before releasing the second carrier, laminating an additional adhesive laminate sheet onto a surface of the laminate on a side where the first carrier has been released,
wherein the additional adhesive laminate sheet includes a third carrier, a third release layer, and a second adhesive layer containing an adhesive material in this order, and
wherein lamination of the additional adhesive laminate sheet onto the laminate is carried out so that the second adhesive layer comes into contact with the surface of the laminate on a side where the first carrier has been released.

### BRIEF DESCRIPTION OF DRAWINGS

Figure 1 is a schematic cross-sectional view illustrating one aspect of the adhesive laminate sheet of the present invention.
Figure 2 is a schematic cross-sectional view illustrating one aspect of a laminate including the adhesive laminate sheet of Figure 1.
Figure 3 is a process flow chart illustrating an example of the method for manufacturing a wiring board of the present invention, shown as schematic cross-sectional views, corresponding to the initial steps ((i) to (iii)).
Figure 4 is a process flow chart illustrating an example of the method for manufacturing a wiring board of the present invention, shown as schematic cross-sectional views, corresponding to the steps ((iv) to (vi)) following the steps shown in Figure 3.
Figure 5 is a process flow chart illustrating an example of the method for manufacturing a wiring board of the present invention, shown as schematic cross-sectional views, corresponding to the steps ((vii) to (ix)) following the steps shown in Figure 4.
Figure 6 is a process flow chart illustrating an example of the method for manufacturing a wiring board of the present invention, shown as schematic cross-sectional views, corresponding to the steps ((x) and (xi)) following the steps shown in Figure 5.
Figure 7 is a process flow chart illustrating an example of a method for manufacturing a laminate using a carrier-attached metal foil, shown as schematic cross-sectional views, corresponding to the initial steps ((i) to (iii)).
Figure 8 is a process flow chart illustrating an example of a method for manufacturing a laminate using a carrier-attached metal foil, shown as schematic cross-sectional views, corresponding to the later steps ((iv) to (vi)) following the steps shown in Figure 7.

### DESCRIPTION OF EMBODIMENTS

### Adhesive Laminate Sheet

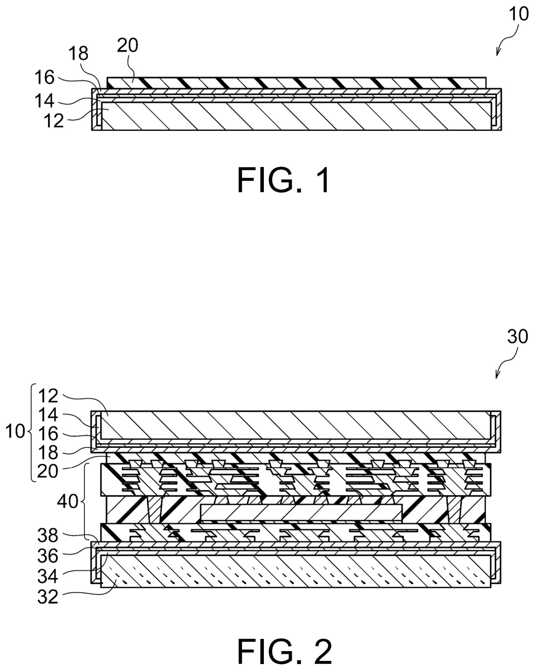

An example of the adhesive laminate sheet of the present invention is schematically illustrated in Figure 1. As shown in Figure 1, an adhesive laminate sheet 10 includes a carrier 12, a release layer 16, and an adhesive layer 20 in this order. The release layer 16 is provided on the carrier 12. The adhesive layer 20 is provided on the release layer 16 and contains an adhesive material. It is preferable that the adhesive laminate sheet 10 further includes a metal layer 18 between the release layer 16 and the adhesive layer 20. Optionally, the adhesive laminate sheet 10 may further include an intermediate layer 14 between the carrier 12 and the release layer 16. Each of the intermediate layer 14, the release layer 16, the metal layer 18, and the adhesive layer 20 may be a single layer composed of one layer or a multilayer composed of two or more layers. As described above, in the adhesive laminate sheet 10, by providing the release layer 16 and the adhesive layer 20 containing an adhesive material on the carrier 12, rapid release and removal after use as a reinforcing sheet can be carried out.

The use of the adhesive laminate sheet 10 as a reinforcing sheet and its subsequent release and removal can be carried out as follows, for example. First, by adhering the adhesive layer 20 side of the adhesive laminate sheet 10 to an adherend (for example, a wiring layer-attached laminate), the adherend is reinforced by the carrier 12 and the like, thereby improving handleability and the like. Then, since the release layer 16 is provided between the carrier 12 and the adhesive layer 20, the carrier 12 (and the intermediate layer 14, if present) that has served its purpose as a reinforcing sheet can be released at the position of the release layer 16. After release of the carrier 12 and the like, the release layer 16 (and the metal layer 18, if present) is removed, thereby exposing most of or all of the surface of the adhesive layer 20. The surface of the adhesive layer 20 thus exposed is then subjected to a method such as bringing a stripping solution into contact therewith, thereby removing the adhesive layer 20. As described above, according to the adhesive laminate sheet 10 of the present invention, after release of the carrier 12 and the like that can function as a reinforcing sheet, the exposed adhesive layer 20 can be directly removed. Accordingly, as compared with conventional methods as disclosed in Patent Literature 7 (JP7112962B), Patent Literature 8 (JP7208011B), and the like, in which, when dissolving or softening a soluble adhesive layer, the reinforcing sheet itself remains in place and the contact area with a dissolving solution and the like is not sufficiently large, the sheet release and removal and the adhesive layer removal can be carried out even more rapidly.

The adhesive layer 20 is preferably a layer that allows the adhesive laminate sheet 10 to be adhered to an adherend with desired adhesion, and that can be removed from the adherend after use. The adhesion mode between the adhesive laminate sheet 10 and the adherend via the adhesive layer 20 is not particularly limited, and may be, for example, mechanical bonding (that is, adhesion by anchor effect), physical interaction (that is, adhesion by van der Waals force), chemical bonding, or the like. Examples of the adhesive material contained in the adhesive layer 20 include a phenolic resin, a urea resin, a melamine resin, an epoxy resin, a polyimide resin, an ethylene-vinyl acetate copolymer resin (EVA), a urethane resin, an acrylic resin, a synthetic rubber, and a starch, with a thermosetting epoxy resin, a thermosetting polyimide resin, a photosensitive polyimide resin, an acrylic resin, a phenolic resin, or a combination thereof being preferable.

In the case where the adhesive laminate sheet 10 is used as a reinforcing sheet for an adherend (for example, a wiring layer-attached laminate) that is to be subjected to a heating treatment at a high temperature (for example, at 260°C for several minutes), it is preferable that the adhesive layer 20 can maintain adhesiveness even after such a heating treatment, and that it can be removed after use. From this viewpoint, it is preferable that the adhesive material contains a thermosetting resin. Preferred examples of the thermosetting resin include a thermosetting epoxy resin, a thermosetting polyimide resin, a thermosetting phenolic resin, a thermosetting melamine resin, and a combination thereof, with a thermosetting epoxy resin being more preferable. Examples of products of the adhesive layer containing a thermosetting epoxy resin include TSA-16 manufactured by Toray Industries, Inc.

The adhesive layer 20 preferably has a thickness of 1 µm or more and 2000 µm or less, more preferably 3 µm or more and 1000 µm or less, further preferably 5 µm or more and 800 µm or less, and particularly preferably 10 µm or more and 500 µm or less. With such a thickness, it becomes easier to control the adhesion to the adherend within a desired range, and the release and removal of the adhesive laminate sheet 10 after use as a reinforcing sheet or the like can be carried out in an even shorter time.

The adhesive layer 20 is preferably a layer that exhibits adhesiveness at room temperature, of course, and that can be dissolved or softened upon contact with a dissolving solution. Accordingly, the adhesive layer 20 preferably contains a solution-soluble resin, and for example, it contains an acid-soluble resin or an alkali-soluble resin. Since such a solution-soluble resin can be dissolved or softened efficiently upon contact with a dissolving solution, removal of the adhesive layer 20 can be carried out more rapidly. In particular, the adhesive layer 20 preferably contains an alkali-soluble resin. Preferred examples of the alkali-soluble resin include the above-described thermosetting resins.

The method for forming the adhesive layer 20 is not particularly limited, and known methods can be adopted. For example, a coating solution in which the adhesive material is dissolved in a solvent can be applied onto the release layer 16 (or the metal layer 18, if present) and dried to evaporate the solvent, thereby forming the adhesive layer 20. Alternatively, a commercially available adhesive film may be placed on the release layer 16 (or the metal layer 18, if present) and bonded thereto by a method such as roll lamination or vacuum lamination.

In the adhesive laminate sheet 10, the ratio of the plan view area of the adhesive layer 20 A_{A} to the plan view area of the carrier 12 A_{C}, A_{A}/A_{C}, is preferably 0.03 or more and 1.0 or less, more preferably 0.05 or more and 0.95 or less, further preferably 0.08 or more and 0.93 or less, and particularly preferably 0.10 or more and 0.90 or less. The plan view areas A_{C} and A_{A} refer to the area of the carrier 12 and the area of the adhesive layer 20 when the adhesive laminate sheet 10 is seen in a plan view, respectively. By forming the adhesive layer 20 sufficiently large relative to the carrier 12 in this manner, the adhesive laminate sheet 10 can be adhered to an adherend stably and reliably. Nevertheless, as described above, since the adhesive laminate sheet 10 can be brought into contact with a dissolving solution or the like in a state where most of or all of the surface of the adhesive layer 20 is exposed after release of the carrier 12, the adhesive layer 20 can be removed in a short time.

In the case where the adhesive laminate sheet 10 is laminated onto an adherend, the carrier 12 typically has a function of reinforcing the adherend and improving its handleability. The carrier 12 preferably has a spring deflection limit Kb_{0.1} of 100 N/mm² or more and 1500 N/mm² or less, more preferably 150 N/mm² or more and 1200 N/mm² or less, and further preferably 200 N/mm² or more and 1000 N/mm² or less, as measured in accordance with the repeated bending test in JIS H 3130-2012.

For reference, the spring deflection limit Kb_{0.1} of various candidate materials is exemplified in Tables 1 and 2 below.

### [Table 1]

**Table 1**

| Material (JIS number) | Temper | Kb_{0.1} |
|---|---|---|
| SUS301CSP stainless steel | 1/2H | 315 |
| | 3/4H | 390 |
| | H | 490 |
| | EH | 590 |
| | SHE(1) | 650 |
| SUS304CSP stainless steel | 1/2H | 275 |
| | 3/4H | 335 |
| | H | 390 |
| SUS631CSP stainless steel | O | 635 |
| | 1/2H | 635 |
| | 3/4H | 835 |
| | H | 980 |
| SUS632J1CSP stainless steel | 1/2H | 1200 |
| | 3/4H | 1400 |
| C1700 copper-beryllium alloy | O | 685 |
| | 1/4H | 785 |
| | 1/2H | 835 |
| | H | 855 |
| C1720 copper-beryllium alloy | O | 735 |
| | 1/4H | 835 |
| | 1/2H | 885 |
| | H | 930 |
| C1720M copper-beryllium alloy * mill-hardened material | OM | 390 |
| | 1/4HM | 440 |
| | 1/2HM | 540 |
| | HM | 635 |

### [Table 2]

**Table 2**

| Material (JIS number) | Temper | Kb_{0.1} |
|---|---|---|
| C5210 phosphor bronze | 1/2H | 245 |
| | H | 390 |
| | EH | 460 |
| | SH | 510 |
| | ESH | 560 |
| C5240 phosphor bronze | H | 430 |
| | EH | 510 |
| | SH | 570 |
| | ESH | 630 |
| | XSH | 700 |
| C7270 copper-nickel-tin alloy | O | 490 |
| | 1/4H | 590 |
| | 1/2H | 635 |
| | H | 685 |
| | EH | 735 |
| | SH | 785 |
| C7270M copper-nickel-tin alloy * mill-hardened material | OM | 440 |
| | 1/4HM | 490 |
| | 1/2HM | 540 |
| | HM | 590 |
| | EHM | 685 |
| | XHM | 785 |
| C7701 nickel silver | 1/2H | 390 |
| | H | 480 |
| | EH | 560 |
| | SH | 620 |
| C1990M copper-titanium alloy, mill-hardened | 1/4HM | 440 |
| | EHM | 590 |

The carrier 12 is preferably composed of resin, metal (including alloys and intermetallic compounds), glass, ceramic, silicon, or a combination thereof, and more preferably composed of metal. In the case where the adhesive laminate sheet 10 is used as a reinforcing sheet, the use of a carrier made of metal provides advantages in that breakage or other problems of the carrier 12 during handling can be effectively prevented, and recycling of the carrier 12 after use becomes possible. Examples of the metal constituting the carrier 12 include, from the viewpoints of the above-described spring deflection limit Kb_{0.1}, Young's modulus, and the like, aluminum (including aluminum alloys), stainless steel, copper (including copper alloys such as bronze, phosphor copper, copper-nickel alloy, and copper-titanium alloy), titanium (including titanium alloys), nickel (including nickel alloys), and duralumin (for example, A2017, A2024, and A7075 in JIS standards), with stainless steel being particularly preferable from the viewpoint of chemical resistance. Examples of the resin include an epoxy resin, a polyimide resin, a polyethylene resin, and a phenolic resin, and a prepreg composed of such a resin and a fiber reinforcing material may also be used. The carrier 12 composed of silicon may be any carrier as long as it contains Si as an element, and a SiO₂ substrate, a SiN substrate, a Si single crystal substrate, and a Si polycrystalline substrate, or the like can be applied. Preferred examples of the glass constituting the carrier 12 include quartz glass, borosilicate glass, alkali-free glass, soda lime glass, aluminosilicate glass, and a combination thereof.

The form of the carrier 12 is not limited to a sheet as long as it can prevent or suppress bending of the adherend, and may be in other forms such as a film, a plate, or a foil, and is preferably in the form of a sheet or a plate. The carrier 12 may also be one in which such sheets, films, plates, foils, and the like are laminated. Typical examples of the carrier 12 include a metal sheet, a resin sheet (particularly a hard resin sheet), and a glass sheet. The thickness of the carrier 12 is preferably 10 µm or more and 1 mm or less, more preferably 50 µm or more and 800 µm or less, and further preferably 100 µm or more and 600 µm or less, from the viewpoints of maintaining the strength of the carrier 12 and facilitating handling of the carrier 12. In the case where the carrier 12 is a metal sheet (for example, a stainless steel sheet), the ten-point average roughness Rz-jis (measured in accordance with JIS B 0601-2001) of the surface of the metal sheet on the side where the release layer 16 (or the intermediate layer 14, if present) is formed is preferably 0.05 µm or more and 500 µm or less, more preferably 0.5 µm or more and 400 µm or less, and further preferably 1 µm or more and 300 µm or less. With such a surface roughness, the anchor effect resulting from surface irregularities makes it easier to control the peel strength between the carrier and the adhesive layer to a desired value.

The intermediate layer 14, which is optionally provided, is interposed between the carrier 12 and the release layer 16, and serves as a layer that contributes to securing adhesion between the carrier 12 and the release layer 16. Examples of the metal constituting the intermediate layer 14 include Cu, Ti, Al, Nb, Zr, Cr, W, Ta, Co, Ag, Ni, In, Sn, Zn, Ga, Mo, and combinations thereof (hereinafter sometimes referred to as metal M); preferably Cu, Ti, Al, Nb, Zr, Cr, W, Ta, Co, Ag, Ni, Mo, and combinations thereof; more preferably Cu, Ti, Zr, Al, Cr, W, Ni, Mo, and combinations thereof; further preferably Cu, Ti, Al, Cr, Ni, Mo, and combinations thereof; and particularly preferably Cu, Ti, Al, Ni, and combinations thereof. The intermediate layer 14 may be a pure metal or an alloy. The metal constituting the intermediate layer 14 may contain impurities resulting from the raw material component, the film formation step, and the like. Moreover, although not particularly limited, in the case of exposure to the air after the film formation of the intermediate layer 14, the presence of oxygen mixed due to the exposure is allowed. The upper limit of the content of the metal is not particularly limited and may be 100 atomic%. The intermediate layer 14 is preferably a layer formed by a physical vapor deposition (PVD) method, and more preferably a layer formed by sputtering. The intermediate layer 14 is particularly preferably a layer formed by a magnetron sputtering method using a metal target from the viewpoint of uniformity of film thickness distribution. The thickness of the intermediate layer 14 is preferably 10 nm or more and 1000 nm or less, more preferably 30 nm or more and 800 nm or less, further preferably 60 nm or more and 600 nm or less, and particularly preferably 100 nm or more and 400 nm or less. With such a thickness, the intermediate layer can have a roughness equivalent to that of the carrier. This thickness is a value measured by analyzing a layer cross section by a transmission electron microscope-energy dispersive X-ray spectrometer (TEM-EDX).

The intermediate layer 14 may have a one-layer configuration or a configuration of two or more layers. In the case where the intermediate layer 14 has a one-layer configuration, the intermediate layer 14 is preferably composed of a layer containing a metal composed of Cu, Al, Ti, Ni, or a combination thereof (for example, an alloy or an intermetallic compound), more preferably Al, Ti, or a combination thereof (for example, an alloy or an intermetallic compound), and further preferably a layer mainly containing Al or a layer mainly containing Ti. On the other hand, in the case where a metal or an alloy whose adhesion to the carrier 12 cannot be said to be sufficiently high is adopted in the intermediate layer 14, it is preferable that the intermediate layer 14 has a two-layer configuration. Preferred examples of the two-layer configuration of the intermediate layer 14 include a laminated structure composed of a Ti-containing layer adjacent to the carrier 12 and a Cu-containing layer adjacent to the release layer 16. In addition, since the release strength varies depending on the constituent elements and the thickness balance of each layer in the two-layer configuration, it is preferable to adjust the constituent elements and thickness of each layer as appropriate. The scope of "metal M-containing layer" as used herein also encompasses alloys containing elements other than metal M to the extent that the releasability from the carrier is not impaired. Accordingly, the intermediate layer 14 can also be referred to as a layer mainly containing metal M. From the above point, the content of metal M in the intermediate layer 14 is preferably 50 atomic% or more and 100 atomic% or less, more preferably 60 atomic% or more and 100 atomic% or less, further preferably 70 atomic% or more and 100 atomic% or less, particularly preferably 80 atomic% or more and 100 atomic% or less, and most preferably 90 atomic% or more and 100 atomic% or less.

In the case where the intermediate layer 14 is composed of an alloy, preferred examples of the alloy include a Ni alloy. The Ni alloy preferably has a Ni content of 45% by weight or more and 98% by weight or less, more preferably 55% by weight or more and 90% by weight or less, and further preferably 65% by weight or more and 85% by weight or less. The preferred Ni alloy is an alloy of Ni with at least one selected from the group consisting of Cr, W, Ta, Co, Cu, Ti, Zr, Si, C, Nd, Nb, and La, and more preferably an alloy of Ni with at least one selected from the group consisting of Cr, W, Cu, and Si. In the case where the intermediate layer 14 is a Ni alloy layer, it is particularly preferable that the layer is formed by a magnetron sputtering method using a Ni alloy target from the viewpoint of uniformity of film thickness distribution.

The release layer 16 is a layer that enables or facilitates the release of the carrier 12 and, when present, the intermediate layer 14. The release layer 16 may be a layer that can be released using a laser release method (laser lift-off, LLO) in addition to a layer that can be released using a method of physically applying a force. When the release layer 16 is composed of a material that can be released by laser lift-off, the release layer 16 may be composed of a resin with its adhesive strength at the interface reduced by laser beam irradiation after curing, or may be a layer of silicon, silicon carbide, metal oxide, or the like that is modified by laser beam irradiation. The release layer 16 may be either an organic release layer or an inorganic release layer, but from the viewpoint of heat resistance, it is preferably an inorganic release layer. Examples of the organic component used for the organic release layer include nitrogen-containing organic compounds, sulfur-containing organic compounds, and carboxylic acids. Examples of the nitrogen-containing organic compounds include triazole compounds and imidazole compounds. On the other hand, examples of the inorganic component used for the inorganic release layer include metal oxides or metal oxynitrides including at least one or more of Ni, Mo, Co, Cr, Fe, Ti, W, P, Zn, Cu, Al, Nb, Zr, Ta, Ag, In, Sn, and Ga, or a carbon layer. Among these in particular, the release layer 16 is preferably a layer containing carbon, more preferably a carbon-containing layer, that is, a layer mainly containing carbon, in terms of ease of release, film formation properties, and the like, further preferably a layer mainly composed of carbon or a hydrocarbon, and particularly preferably a layer composed of amorphous carbon, which is a hard carbon film. In this case, the release layer 16 (that is, a carbon-containing layer) preferably has a carbon concentration of 60 atomic% or more, more preferably 70 atomic% or more, further preferably 80 atomic% or more, and particularly preferably 85 atomic% or more as measured by x-ray photoelectron spectroscopy (XPS). The upper limit value of the carbon concentration is not particularly limited and may be 100 atomic% but is practically 98 atomic% or less. The release layer 16 can contain impurities (for example, oxygen and hydrogen, which are derived from the surrounding environment such as the atmosphere). In the release layer 16, atoms of metals of types other than the metal contained as the release layer 16 can be mixed due to the film formation method of the metal layer 18 or the like. In the case where a carbon-containing layer is used as the release layer 16, the interdiffusivity and reactivity with the carrier are low, and even if the layer is subjected to pressing at a temperature exceeding 300°C, formation of metal bonds due to high-temperature heating between the metal layer (if present) and the bonding interface can be prevented to maintain a state where the release and removal of the carrier is easy. This release layer 16 is also preferably a layer formed by a vapor phase method such as sputtering, in terms of suppressing excessive impurities in the release layer 16 and of enabling continuous production with the film formation of the intermediate layer 14, which is optionally provided. In the case where a carbon-containing layer is used as the release layer 16, its thickness is preferably 1 nm or more and 20 nm or less, and more preferably 1 nm or more and 10 nm or less. With such a thickness, the release layer can have a roughness equivalent to that of the carrier and possess a release function. This thickness is a value measured by analyzing a layer cross section by a transmission electron microscope-energy dispersive X-ray spectrometer (TEM-EDX).

The release layer 16 may be a layer including a metal oxide layer and a carbon-containing layer, respectively, or a layer including both a metal oxide and carbon. Particularly, when the adhesive laminate sheet 10 includes the intermediate layer 14 and the metal layer 18, the carbon-containing layer can contribute to the stable release of the carrier 12, and the metal oxide layer can inhibit the diffusion of the metal elements derived from the intermediate layer 14 and the metal layer 18, accompanying heating. As a result, even after the heating at a temperature as high as, for example, 350°C or more, stable releasability can be maintained. The metal oxide layer is preferably a layer including an oxide of metals composed of Cu, Ti, Al, Nb, Zr, Cr, W, Ta, Co, Ag, Ni, In, Sn, Zn, Ga, Mo, or combinations thereof. The metal oxide layer is particularly preferably a layer formed by a reactive sputtering method in which sputtering is performed under an oxidizing atmosphere, using a metal target, in terms of being able to easily control film thickness by the adjustment of film formation time. The thickness of the metal oxide layer is preferably 0.1 nm or more and 100 nm or less. The upper limit value of the thickness of the metal oxide layer is more preferably 60 nm or less, further preferably 30 nm or less, and particularly preferably 10 nm or less. This thickness is a value measured by analyzing a layer cross section by a transmission electron microscope-energy dispersive X-ray spectrometer (TEM-EDX). At this time, the order in which the metal oxide layer and the carbon layer are laminated as the release layer 16 is not particularly limited. The release layer 16 may be present in a state of a mixed phase in which the boundary between the metal oxide layer and the carbon-containing layer is not clearly identified (that is, a layer containing both metal oxide and carbon).

Similarly, from the viewpoint of maintaining stable releasability even after heat treatment at high temperatures, the release layer 16 may be a metal-containing layer in which the surface on the side adjacent to the adhesive layer 20 (or the metal layer 18, if present) is a fluorination-treated surface and/or a nitriding-treated surface. In the metal-containing layer, a region in which the sum of the content of fluorine and the content of nitrogen is 1.0 atomic% or more (hereinafter referred to as a "(F + N) region") is preferably present over a thickness of 10 nm or more, and the (F + N) region is preferably present on the adhesive layer 20 side of the metal-containing layer. The thickness (in terms of SiO₂) of the (F + N) region is a value specified by performing the depth profile elemental analysis of the adhesive laminate sheet 10 using XPS. The fluorination-treated surface or the nitriding-treated surface can be preferably formed by reactive ion etching (RIE) or a reactive sputtering method. On the other hand, the metal element included in the metal-containing layer preferably has a negative standard electrode potential. Preferred examples of the metal element included in the metal-containing layer include Cu, Ag, Sn, Zn, Ti, Al, Nb, Zr, W, Ta, Mo, and combinations thereof (for example, alloys and intermetallic compounds). The content of the metal element in the metal-containing layer is preferably 50 atomic% or more and 100 atomic% or less. The metal-containing layer may be a single layer composed of one layer or a multilayer composed of two or more layers. The thickness of the entire metal-containing layer is preferably 10 nm or more and 1000 nm or less, more preferably 30 nm or more and 500 nm or less, further preferably 50 nm or more and 400 nm or less, and particularly preferably 100 nm or more and 300 nm or less. The thickness of the metal-containing layer itself is a value measured by analyzing a layer cross section by a transmission electron microscope-energy dispersive X-ray spectrometer (TEM-EDX).

Alternatively, the release layer 16 may be a metal oxynitride-containing layer instead of a carbon layer or the like. The surface of the metal oxynitride-containing layer opposite to the carrier 12 (that is, on the adhesive layer 20 side) preferably includes at least one metal oxynitride selected from the group consisting of TaON, NiON, TiON, NiWON, and MoON. In the case where the adhesive laminate sheet 10 include the metal layer 18, in terms of ensuring the adhesion between the carrier 12 and the metal layer 18, the surface of the metal oxynitride-containing layer on the carrier 12 side preferably includes at least one selected from the group consisting of Cu, Ti, Ta, Cr, Ni, Al, Mo, Zn, W, TiN, and TaN. Thus, the number of foreign matter particles on the surface of the metal layer 18 is suppressed, and even after heating at high temperatures for a long time, stable release strength can be maintained. The thickness of the metal oxynitride-containing layer is preferably 5 nm or more and 500 nm or less, more preferably 10 nm or more and 400 nm or less, further preferably 20 nm or more and 200 nm or less, and particularly preferably 30 nm or more and 100 nm or less. This thickness is a value measured by analyzing a layer cross section by a transmission electron microscope-energy dispersive X-ray spectrometer (TEM-EDX).

The metal layer 18, which is optionally provided, is a layer composed of metal. By interposing the metal layer 18 between the release layer 16 and the adhesive layer 20, the carrier 12 (and the intermediate layer 14, if present) can be released even more smoothly. The metal layer 18 may have a one-layer configuration or a configuration of two or more layers. Preferred examples of the metal constituting the metal layer 18 include Ti, Cu, Al, Nb, Zr, Cr, W, Ta, Co, Ag, Ni, In, Sn, Zn, Ga, Mo, and combinations thereof; more preferably Cu, Ti, Al, Nb, Zr, Cr, W, Ta, Co, Ag, Ni, Mo, and combinations thereof; further preferably Cu, Ti, Al, Cr, Ni, Mo, and combinations thereof; and particularly preferably Cu, Ti, Al, Ni, and combinations thereof. The metal layer 18 may be a pure metal or an alloy. The metal constituting the metal layer 18 may contain impurities resulting from the raw material component, the film formation step, and the like. The upper limit of the content of the metal is not particularly limited and may be 100 atomic%. The metal layer 18 is preferably a layer formed by a physical vapor deposition (PVD) method, and more preferably a layer formed by sputtering. The thickness of the metal layer 18 (the overall thickness) is preferably 10 nm or more and 1000 nm or less, preferably 20 nm or more and 900 nm or less, more preferably 30 nm or more and 800 nm or less, further preferably 40 nm or more and 700 nm or less, and particularly preferably 50 nm or more and 500 nm or less. By doing so, removal of the metal layer 18 can be carried out in an extremely short time, and release and removal of the adhesive laminate sheet 10 after being used as a reinforcing sheet can be carried out even more rapidly. The thickness of the metal layer 18 is a value measured by analyzing a layer cross section by a transmission electron microscope-energy dispersive X-ray spectrometer (TEM-EDX).

Formation of each layer of the intermediate layer 14 (if present), the release layer 16, and the metal layer 18 (if present) is preferably carried out by a physical vapor deposition (PVD) method. Examples of the physical vapor deposition (PVD) method include sputtering, vacuum deposition, and ion plating, but in terms of being able to control film thickness over a wide range, such as 0.05 nm or more and 5000 nm or less and of being able to ensure film thickness uniformity over a wide width or area, sputtering is most preferable. In particular, forming all layers of the intermediate layer 14 (if present), the release layer 16, and the metal layer 18 (if present) by the sputtering method significantly improves manufacturing efficiency. Accordingly, the intermediate layer 14 (if present), the release layer 16, and the metal layer 18 (if present) are preferably all physical vapor deposition (PVD) films, that is, films formed by a physical vapor deposition (PVD) method, and more preferably sputter films, that is, films formed by a sputtering method.

Film formation by the physical vapor deposition (PVD) method may be carried out using a known vapor deposition apparatus under known conditions, and is not particularly limited. For example, in the case of adopting a sputtering method, the sputtering technique may be any of various known methods such as magnetron sputtering, bipolar sputtering, and facing target sputtering, with magnetron sputtering being preferable in terms of its high film formation rate and productivity. Sputtering may be carried out using either a DC (direct current) or RF (radio frequency) power source. As for the target shape, a widely known plate-type target may be used; however, from the viewpoint of target use efficiency, it is desirable to use a cylindrical target. The purity of the target is preferably 99.9% or more. As the gas for sputtering, it is preferable to use an inert gas such as argon gas. The flow rate of argon gas may be determined as appropriate depending on the sputtering chamber size and film formation conditions, and is not particularly limited. In addition, from the viewpoint of performing continuous film formation without operational failures such as abnormal discharge or poor plasma irradiation, it is preferable that the pressure during film formation is in the range of 0.1 Pa or more and 20 Pa or less. This pressure range may be set by adjusting the film formation power and the flow rate of argon gas depending on the apparatus structure, capacity, vacuum pump exhaust capacity, rated capacity of the film formation power source, and the like. In addition, the sputtering power may be set as appropriate in the range of 0.05 W/cm² or more and 10.0 W/cm² or less per unit area of the target in consideration of film thickness uniformity, productivity, and other factors for film formation.

In the case where the adhesive laminate sheet 10 has the metal layer 18 or the like, the end surface of the carrier 12 is preferably covered by the extension of the metal layer 18, optionally the intermediate layer 14, and optionally the release layer 16 (that is, at least the metal layer 18, for example, the metal layer 18 and the intermediate layer 14) to the end surface. That is, not only the surface but also the end surface of the carrier 12 is preferably covered with at least the metal layer 18. By covering the end surface as well, it is possible to prevent the infiltration of chemical liquids into the carrier 12 during the manufacturing process of the wiring substrate and the like, and also to strongly prevent chipping due to release at the side end when the adhesive laminate sheet 10 is handled, that is, chipping of the film on the release layer 16 (that is, the metal layer 18). The covered region on the end face of the carrier 12 is preferably a region 0.1 mm or more and more preferably 0.2 mm or more from the surface of the carrier 12 toward the thickness direction (that is, the direction perpendicular to the carrier surface), and is further preferably throughout the end face of the carrier 12.

The thickness of the entire adhesive laminate sheet 10 is not particularly limited, but is preferably 100 µm or more and 5000 µm or less, more preferably 130 µm or more and 4800 µm or less, further preferably 150 µm or more and 4500 µm or less, and particularly preferably 200 µm or more and 4000 µm or less. The size of the adhesive laminate sheet 10 is not particularly limited, but is preferably a diameter of 10 cm or more or 10 cm square or more, more preferably a diameter of 20 cm or more or 20 cm square or more, and further preferably a diameter of 25 cm or more or 25 cm square or more. The upper limit of the size of the adhesive laminate sheet 10 is not particularly limited, but a diameter of 1000 cm or 1000 cm square can be cited as one reference. In addition, the adhesive laminate sheet 10 is in a form that can be handled individually by itself.

### Laminate

According to a preferred aspect of the present invention, there is provided a laminate including the adhesive laminate sheet. An example of the laminate of the present invention is illustrated in Figure 2. As shown in Figure 2, a laminate 30 includes the adhesive laminate sheet 10, a resin-containing layer 40 provided on the adhesive layer 20 of the adhesive laminate sheet 10, and an additional metal layer 38 provided on the resin-containing layer 40. Optionally, the laminate 30 may further include an additional release layer 36 provided on the additional metal layer 38, and an additional carrier 32 provided on the additional release layer 36. In addition, the laminate 30 may further include an additional intermediate layer 34 between the additional release layer 36 and the additional carrier 32.

The laminate 30 corresponds to, in the method for manufacturing a wiring board described later, an intermediate product after laminating an adhesive laminate sheet 70 onto a laminate 50, or an intermediate product after releasing a first carrier 52 and the like. Accordingly, the preferred aspects of the laminate 50 described later apply directly as preferred aspects of the laminate 30.

### Method for Manufacturing Wiring Board

According to another preferred aspect of the present invention, there is provided a method for manufacturing a wiring board using the adhesive laminate sheet. This method includes the steps of: (1) providing a laminate; (2) laminating an adhesive laminate sheet; (3) releasing a first carrier; (4) optionally laminating an additional adhesive laminate sheet; (5) releasing a second carrier; (6) removing a second release layer; and (7) removing an adhesive layer. Each of the steps (1) to (7) will be described below with reference to the drawings.

### (1) Providing Laminate

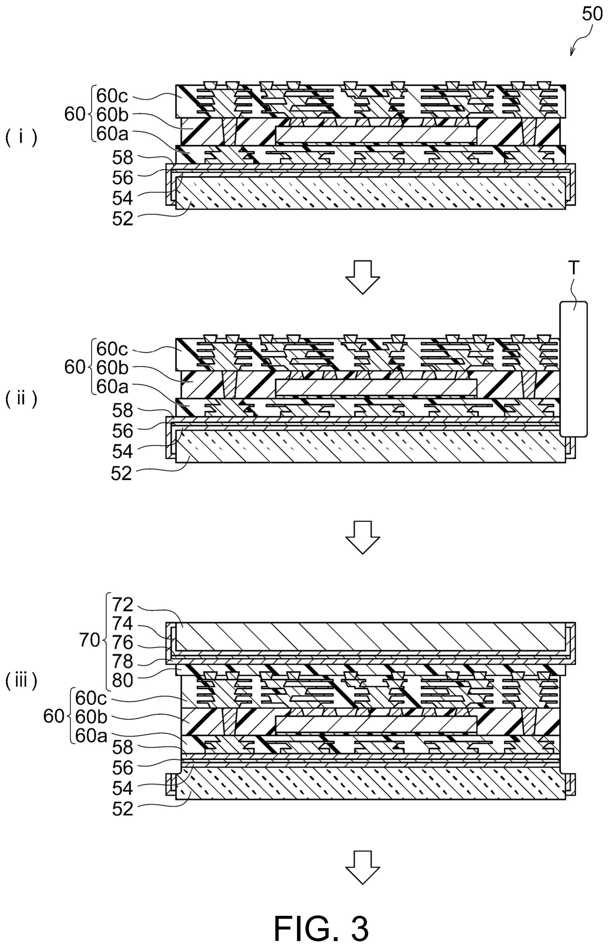

An example of the method for manufacturing a wiring board of the present invention is illustrated in Figures 3 to 6. First, as shown in Figure 3(i), a laminate 50 is provided. This laminate 50 includes a first carrier 52, optionally a first intermediate layer 54 (an optional layer), a first release layer 56, a first metal layer 58, and a resin-containing layer 60 in this order. The first carrier 52, the first intermediate layer 54, the first release layer 56, and the first metal layer 58 may correspond to a carrier-attached metal foil as disclosed in Patent Literature 2 (WO2017/150283) and Patent Literature 3 (WO2017/150284), and are not particularly limited. Alternatively, these various layers may correspond to the preferred aspects of the carrier 12, intermediate layer 14, release layer 16, and metal layer 18 described above with respect to the adhesive laminate sheet 10.

The resin-containing layer 60 is a layer that contains a resin, and preferably includes a redistribution layer. In the present invention, the redistribution layer refers to a layer including an insulating layer and a wiring layer formed inside and/or on the surface of the insulating layer. As described later, the resin-containing layer 60 preferably includes a first redistribution layer 60a provided on the first metal layer 58, a mold resin layer 60b provided on the first redistribution layer 60a, and a second redistribution layer 60c provided on the mold resin layer 60b. The mold resin layer 60b is a layer that contains a resin for sealing electronic elements such as chips. Accordingly, electronic elements may be embedded in the mold resin layer 60b. Examples of the electronic elements include semiconductor elements, chip capacitors, and resistors. Preferred examples of the resin contained in the resin-containing layer 60 (typically the mold resin layer 60b) include an epoxy resin and a phenolic resin.

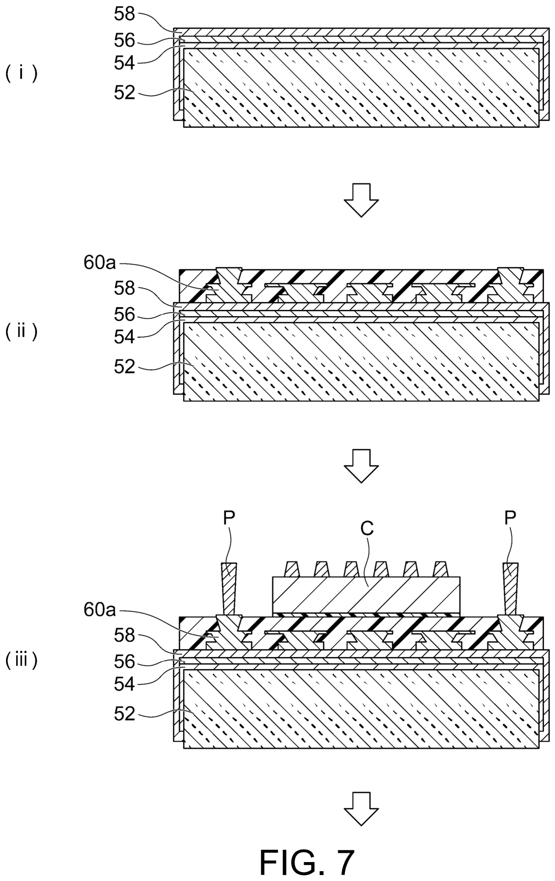

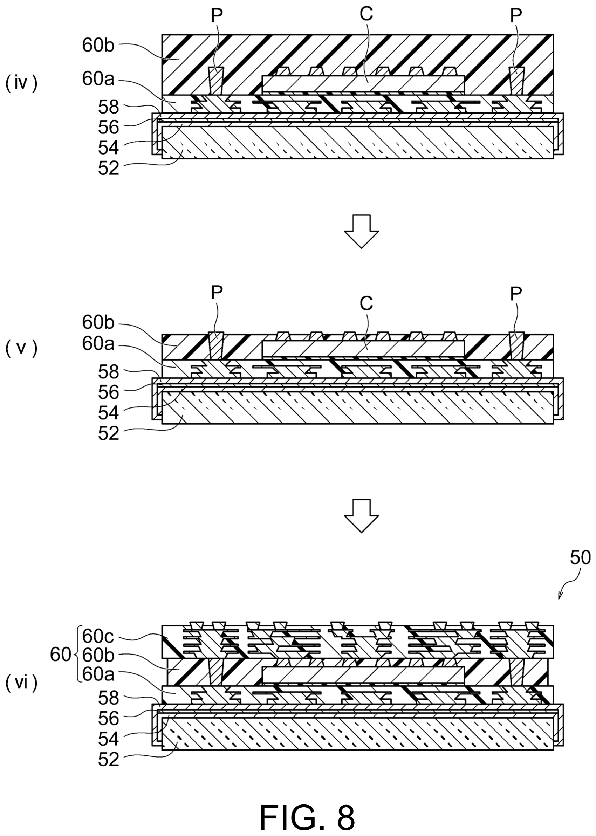

An example of a preferred method for forming the resin-containing layer 60 is illustrated in Figures 7 and 8. First, a carrier-attached metal foil including a first intermediate layer 54 (an optional layer), a first release layer 56, and a first metal layer 58 in this order on a first carrier 52 is provided (Figure 7(i)). On the surface of the first metal layer 58 of this carrier-attached metal foil, a wiring layer and an insulating layer are formed by a coreless build-up method to obtain a first redistribution layer 60a (Figure 7(ii)). Specifically, a photoresist is laminated onto the first metal layer 58, exposed and developed to form a predetermined pattern, thereby forming a resist pattern. Then, electroplating (for example, copper electroplating) is performed in the spaces of the resist pattern, and after removing the resist pattern, unnecessary portions of the first metal layer 58 exposed by the resist pattern removal (that is, portions where no wiring pattern is formed) are removed by etching to form a first wiring layer. Thereafter, on the surface of the carrier-attached metal foil where the first wiring layer has been formed, an insulating layer and an n-th wiring layer (n is an integer of 2 or more) are alternately formed. In this way, the first redistribution layer 60a, which includes the insulating layer and the wiring layer formed inside and/or on the surface of the insulating layer, is obtained. Optionally, a pillar (columnar electrode) P may be formed or a chip C may be mounted on the first redistribution layer 60a (Figure 7(iii)). By embedding the pillar P, the chip C, and the like in an insulating resin, a mold resin layer 60b may be formed (Figure 8(iv)). In addition, by polishing the surface of the mold resin layer 60b, the pillar P and the like may be exposed from the mold resin layer 60b (Figure 8(v)). Preferred examples of surface polishing include grinding using a grindstone and chemical mechanical polishing (CMP). Thereafter, a second redistribution layer 60c is formed on the surface of the mold resin layer 60b by the above-described coreless build-up method (Figure 8(vi)). In this way, a laminate 50 including, on the first metal layer 58 of the carrier-attached metal foil, the resin-containing layer 60 including the first redistribution layer 60a, the mold resin layer 60b, and the second redistribution layer 60c can be preferably prepared.

Optionally, before laminating the adhesive laminate sheet described later, the periphery of the first carrier 52, the first intermediate layer 54, the first release layer 56, the first metal layer 58, and/or the resin-containing layer 60 may be trimmed (Figure 3(ii)). By doing so, using the trimmed portion as a trigger, release of the first carrier 52 and the like described later can be carried out even more easily. The trimming method is not particularly limited, and for example, a cutting tool T (such as a cutter) as shown in Figure 3(ii), or a machine tool (such as a cutting blade) can be used.

### (2) Laminating Adhesive Laminate Sheet

An adhesive laminate sheet 70 is laminated onto the laminate 50 (Figure 3(iii)). The adhesive laminate sheet 70 includes a second carrier 72, optionally a second intermediate layer 74 (an optional layer), a second release layer 76, optionally a second metal layer 78 (an optional layer), and an adhesive layer 80 containing an adhesive material in this order. Then, the adhesive laminate sheet 70 is laminated onto the laminate 50 so that the adhesive layer 80 comes into contact with the resin-containing layer 60. By doing so, the resin-containing layer 60 is reinforced by the second carrier 72 and the like, and local large bending of the resin-containing layer 60, when the first carrier 52 is released, for example, can be prevented or suppressed. In particular, in the case where the resin-containing layer 60 includes a redistribution layer, disconnection or delamination of the wiring layer on the surface of and/or inside the redistribution layer can be avoided, thereby improving the connection reliability of the redistribution layer. In addition, since bending is effectively prevented or suppressed, the flatness (coplanarity) of the redistribution layer surface can also be improved. Note that, when laminating the adhesive laminate sheet 70 onto the laminate 50, an additional release layer (not shown) may be interposed between the adhesive layer 80 and the resin-containing layer 60. By doing so, after the release of the first carrier 52 described later, when releasing the second carrier 72, the second carrier 72 and the like can be released and removed using the additional release layer as a starting point, and the amount of adhesive layer 80 residue that may remain on the surface of the resin-containing layer 60 can be significantly reduced. The preferred aspects of the additional release layer are not particularly limited, and may correspond to the preferred aspects of the release layer 16 described above, for example.

The preferred aspects of the adhesive laminate sheet 10 described above are also applicable to the adhesive laminate sheet 70 as they are. That is, the second carrier 72, the second intermediate layer 74, the second release layer 76, the second metal layer 78, and the adhesive layer 80 may correspond to the carrier 12, the intermediate layer 14, the release layer 16, the metal layer 18, and the adhesive layer 20 described above, respectively. In the case where the adhesive layer 80 contains a thermosetting resin as an adhesive material, it is preferable to perform a curing treatment (cure treatment) after laminating the adhesive laminate sheet 70 onto the laminate 50. The conditions of the curing treatment can be determined as appropriate depending on the type of the thermosetting resin and other factors, and are not particularly limited.

It is preferable that the second carrier 72 has a Vickers hardness lower than that of the first carrier 52. By doing so, the second carrier 72 itself can bend, thereby effectively releasing stress that may occur during lamination or release, and as a result, bending of the resin-containing layer 60 can be prevented or suppressed even more effectively. The Vickers hardness of the second carrier 72 is preferably 2% or more and 99% or less, more preferably 6% or more and 90% or less, and further preferably 10% or more and 85% or less, of the Vickers hardness of the first carrier 52. Preferably, the Vickers hardness of the second carrier 72 is 50 HV or more and 700 HV or less, and the Vickers hardness of the first carrier 52 is 500 HV or more and 3000 HV or less. More preferably, the Vickers hardness of the second carrier 72 is 150 HV or more and 550 HV or less, and the Vickers hardness of the first carrier 52 is 550 HV or more and 2500 HV or less. Further preferably, the Vickers hardness of the second carrier 72 is 200 HV or more and 500 HV or less, and the Vickers hardness of the first carrier 52 is 600 HV or more and 2000 HV or less. Note that the Vickers hardness as used herein is measured in accordance with the "Vickers hardness test" described in JIS Z 2244-2009.

For reference, the Vickers hardness HV of various candidate materials are exemplified as follows: sapphire glass (2300 HV), cemented carbide (1700 HV), cermet (1650 HV), quartz (crystal) (1103 HV), SKH56 (high-speed tool steel material, high-speed steel) (722 HV), tempered glass (640 HV), SUS440C (stainless steel) (615 HV), SUS630 (stainless steel) (375 HV), titanium alloy type 60 (alloy 64) (around 280 HV), Inconel (heat-resistant nickel alloy) (150 HV or more and 280 HV or less), S45C (carbon steel for machine structural use) (201 HV or more and 269 HV or less), Hastelloy alloy (corrosion-resistant nickel alloy) (100 HV or more and 230 HV or less), SUS304 (stainless steel) (187 HV), SUS430 (stainless steel) (183 HV), cast iron (160 HV or more and 180 HV or less), titanium alloy (110 HV or more and 150 HV or less), brass (80 HV or more and 150 HV or less), and bronze (50 HV or more and 100 HV or less).

### (3) Releasing First Carrier

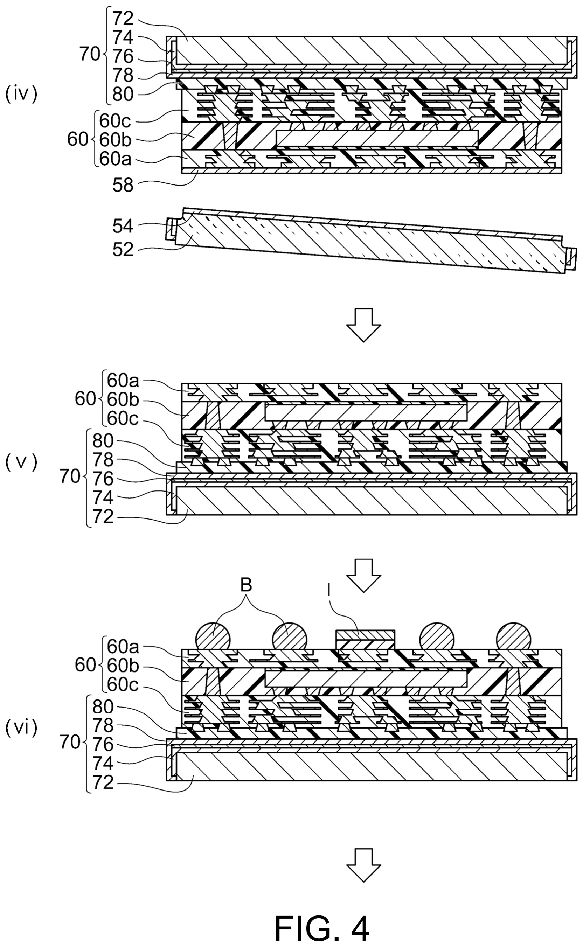

From the laminate 50 onto which the adhesive laminate sheet 70 has been laminated, the first carrier 52 (and the first intermediate layer 54, if present) is released via the first release layer 56 (Figure 4(iv)). At this time, since the second carrier 72 and the like reinforce the resin-containing layer 60, local large bending of the resin-containing layer 60 during release of the first carrier 52 and the like can be prevented. That is, while the first carrier 52 is being released, the second carrier 72 and the like can reinforce the resin-containing layer 60 so as to resist the release force, thereby effectively preventing or suppressing bending. It is preferable that the release of the first carrier 52 is carried out by a laser lift-off method in which release is performed with a laser, or by a mechanical method in which release is performed by applying a physical force using a machine.

Optionally, from the laminate 50 after the first carrier 52 has been released, the remaining first release layer 56 and the first metal layer 58 may be removed (Figure 4(v)). The method for removing the first release layer 56 and the first metal layer 58 is not particularly limited, and a known method may be selected as appropriate depending on the material of the first release layer 56 and the first metal layer 58, and other factors. For example, in the case where the first release layer 56 is a carbon layer, the first release layer 56 can be preferably removed by carrying out an oxygen plasma treatment on the laminate. In addition, the removal of the first metal layer 58 can be carried out by, for example, bringing it into contact with an etching solution capable of dissolving the first metal layer 58.

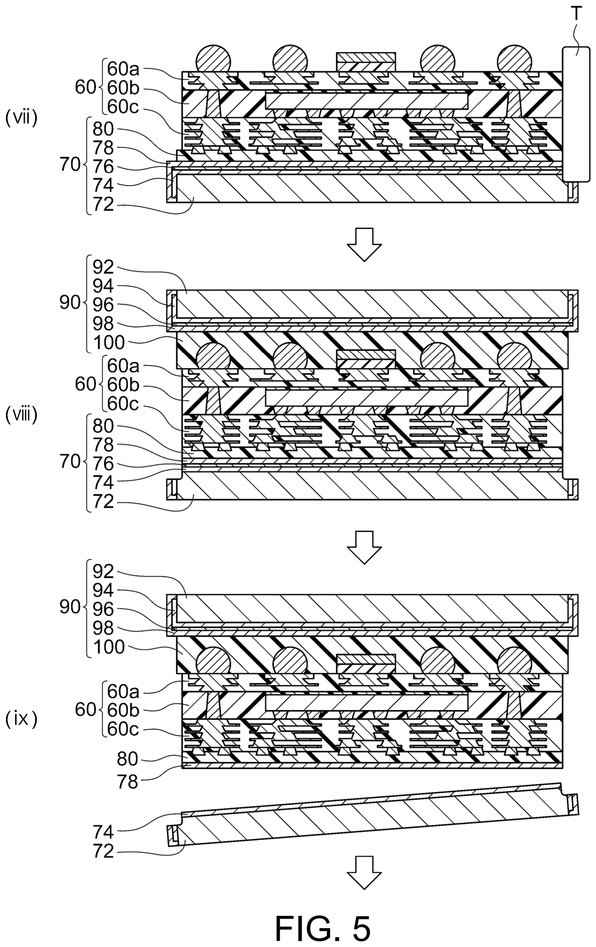

After removal of the first release layer 56 and the first metal layer 58, various electronic elements such as an integrated passive device I, a solder ball B, and the like may be mounted on the resin-containing layer 60 (for example, the first redistribution layer 60a) by a known method (Figure 4(vi)), and resin sealing may be performed thereafter. Moreover, in order to smoothly release the second carrier 72 described later, the periphery of the adhesive laminate sheet 70 (for example, the second carrier 72, the second intermediate layer 74, the second release layer 76, and/or the second metal layer 78) may be trimmed by using a cutting tool T or the like (Figure 5(vii)).

Optionally, after laminating the adhesive laminate sheet 70 and before releasing the second carrier 72 described later, the laminate 50 may be heated to 100°C or higher and 350°C or lower (preferably 200°C or higher and 300°C or lower). Such a heating treatment may be carried out for the purpose of, for example, reflow soldering of the various electronic elements described above.

### (4) Laminating Additional Adhesive Laminate Sheet (Optional Step)

Optionally, after releasing the first carrier 52 and before releasing the second carrier 72 described later, an additional adhesive laminate sheet 90 is laminated onto the surface of the laminate 50 on the side where the first carrier 52 has been released (see Figure 5(viii)). The additional adhesive laminate sheet 90 includes a third carrier 92, optionally a third intermediate layer 94 (an optional layer), a third release layer 96, optionally a third metal layer 98 (an optional layer), and a second adhesive layer 100 containing an adhesive material in this order. Then, the lamination of the additional adhesive laminate sheet 90 onto the laminate 50 is carried out so that the second adhesive layer 100 comes into contact with the surface of the laminate 50 on the side where the first carrier 52 has been released. By doing so, the handleability of the laminate after release of the second carrier 72 is improved, and local bending of the resin-containing layer 60 can also be even further prevented or suppressed. Note that, in the case where an integrated passive device I, a solder ball B, and the like are mounted on the resin-containing layer 60 (for example, the first redistribution layer 60a) after the release of the first carrier 52 and the like, it is preferable to laminate the additional adhesive laminate sheet 90 so that the solder ball B and the like are embedded in the second adhesive layer 100, as shown in Figure 5(viii). Accordingly, it is preferable that the thickness of the second adhesive layer 100 is larger than the height of the solder ball B and the like mounted on the resin-containing layer 60.

The preferred aspects of the adhesive laminate sheet 10 described above are also applicable to the additional adhesive laminate sheet 90 as they are. That is, the third carrier 92, the third intermediate layer 94, the third release layer 96, the third metal layer 98, and the second adhesive layer 100 may correspond to the carrier 12, the intermediate layer 14, the release layer 16, the metal layer 18, and the adhesive layer 20 described above, respectively.

### (5) Releasing Second Carrier

The second carrier 72 is released from the laminate 50, from which the first carrier 52 has been released, via the second release layer 76 (Figure 5(ix)). By first releasing and removing the second carrier 72, which has served its purpose as a reinforcing sheet, the removal of the second release layer 76, the second metal layer 78 (if present), and the adhesive layer 80 described later can be carried out smoothly.

The method for releasing the second carrier 72 may be determined as appropriate depending on the material of the second release layer 76 and other factors, and is not particularly limited. For example, the above-described laser lift-off method or mechanical method can be preferably adopted.

### (6) Removing Second Release Layer

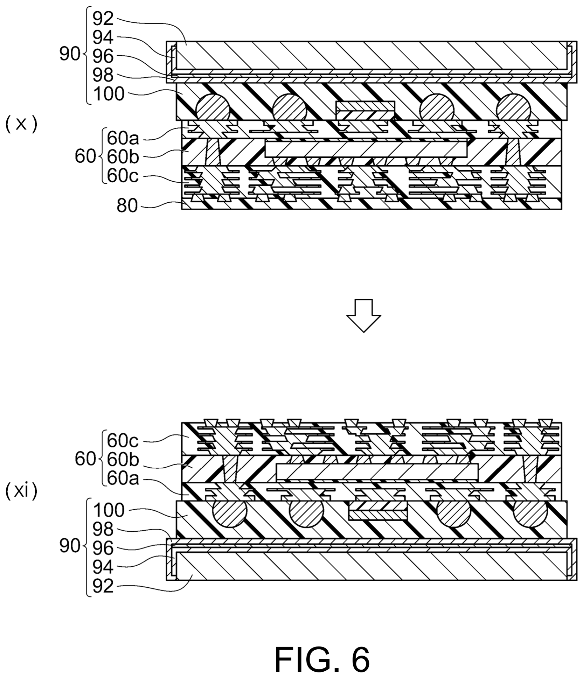

From the laminate 50 from which the second carrier 72 has been released, the second release layer 76 (and the second metal layer 78, if present) is removed, thereby exposing the adhesive layer 80 (Figure 6(x)). The method for removing the second release layer 76 is not particularly limited, and a known method may be selected as appropriate depending on the material of the second release layer 76 and other factors. For example, in the case where the second release layer 76 is a carbon layer, the second release layer 76 can be preferably removed by carrying out an oxygen plasma treatment on the laminate 50. In cases such as when the adhesive laminate sheet 70 includes the second metal layer 78 and the remaining amount of the second release layer 76 on the laminate 50 is small, instead of removing the second release layer 76 alone, the removal of the second release layer 76 and the second metal layer 78 may be carried out at the same time. That is, by removing the second metal layer 78 first, the removal of the second release layer 76 can also be carried out. The removal of the second metal layer 78 can be carried out by, for example, bringing it into contact with an etching solution capable of dissolving the second metal layer 78.

### (7) Removing Adhesive Layer

The adhesive layer 80 is removed from the laminate 50 from which the second release layer 76 and the like have been removed (Figure 6(xi)). The method for removing the adhesive layer 80 is not particularly limited, and a known method may be selected as appropriate depending on the material of the adhesive layer 80 and other factors. For example, the removal of the adhesive layer 80 can be performed by bringing it into contact with a solution capable of dissolving the adhesive layer 80, thereby dissolving or softening it. In any case, according to the present invention, since the adhesive layer 80 can be directly removed without interposing a reinforcing sheet (such as the second carrier 72), release and removal of the adhesive laminate sheet 70 can be achieved in a short time.

After removal of the adhesive layer 80, steps such as mounting electronic elements, such as chips, on the exposed resin-containing layer 60 (for example, the second redistribution layer 60c) may be further carried out to form a wiring board. Together with the chip C that may be embedded in the resin-containing layer 60 (for example, the mold resin layer 60b) described above, a plurality of IC packages can be stacked and mounted on the substrate to improve the degree of integration. In addition, the third carrier 92, the third intermediate layer 94 (if present), the third release layer 96, the third metal layer 98 (if present), and the second adhesive layer 100 may be removed by a method similar to that used for the adhesive laminate sheet 70. In any case, by carrying out various known treatments on the laminate 50, it can be made into a wiring board as a final product.

Examples of the electronic elements assumed to be mounted on the resin-containing layer 60 in the optional step include semiconductor elements, chip capacitors, and resistors, as described above. Examples of the method for mounting electronic elements include a flip chip mounting method and a die bonding method. The flip chip mounting method is a method in which mounting pads of the electronic elements are bonded to the redistribution layer or the like. On these mounting pads, pillars, solder bumps, or the like may be formed, and prior to mounting, a sealing resin film such as a non-conductive film (NCF) may be adhered to the surface of the redistribution layer. The bonding is preferably carried out using a low-melting-point metal such as solder, but an anisotropic conductive film or the like may also be used. The die-bonding adhesive method is a method in which the surface on the opposite side to the mounting pad surface of the electronic elements is adhered to the redistribution layer. For this adhesion, it is preferable to use a paste or film that is a resin composition containing a thermosetting resin and a thermally conductive inorganic filler.

### EXAMPLES

The present invention will be described more specifically by the following examples.

### Example 1

After laminating a resin-containing layer onto a carrier-attached metal foil to obtain a laminate, an adhesive laminate sheet was adhered to the laminate. Thereafter, the adhesive laminate sheet and the like were released and removed. Specifically, the procedure was as follows.

### (1) Providing Laminate

A glass substrate (material: soda lime glass) with a size of 100 mm square and a thickness of 1.1 mm was provided as the first carrier 52. On the first carrier 52, a titanium layer (thickness 50 nm) and a copper layer (thickness 200 nm) as the first intermediate layer 54 having a two-layer configuration, an amorphous carbon layer (thickness 6 nm) as the first release layer 56, and a titanium layer (thickness 100 nm) and a copper layer (thickness 300 nm) as the first metal layer 58 having a two-layer configuration were deposited by sputtering in this order to obtain the carrier-attached metal foil. At this time, the first metal layer 58 was deposited so as to extend out to the end surfaces of the carrier 12, thereby covering the end portions of the first release layer 56.

On the first metal layer 58 (metal foil) of the carrier-attached metal foil, an insulating layer (material: polyimide resin) with a size of 100 mm square and a thickness of 30 µm was formed as the resin-containing layer 60 to obtain the laminate 50 (see Figure 3(i)). Thereafter, the peripheral portions (width 10 mm) of the laminate 50 were trimmed using a cutter (see Figure 3(ii)).

### (2) Laminating Adhesive Laminate Sheet

A stainless steel sheet with a size of 130 mm square and a thickness of 0.3 mm was provided as the second carrier 72. On the second carrier 72, a titanium layer (thickness 50 nm) and a copper layer (thickness 200 nm) as the second intermediate layer 74 having a two-layer configuration, an amorphous carbon layer (thickness 6 nm) as the second release layer 76, and a titanium layer (thickness 100 nm) and a copper layer (thickness 300 nm) as the second metal layer 78 having a two-layer configuration were deposited by sputtering in this order. Thereafter, on the second metal layer 78, a thermosetting epoxy resin film (TSA-16 manufactured by Toray Industries, Inc.) with a size of 100 mm square and a thickness of 20 µm was placed as the adhesive layer 80, and vacuum lamination was carried out under the conditions of a pressure of 0.5 MPa and 80°C for 1 minute to obtain the adhesive laminate sheet 70.

The obtained adhesive laminate sheet 70 was laminated onto the laminate 50 so that the adhesive layer 80 came into contact with the resin-containing layer 60, and vacuum lamination was carried out under the conditions of a pressure of 0.2 MPa and 80°C for 1 minute. Thereafter, as a cure treatment, a heat treatment was carried out at 100°C for 1 hour in an ambient atmosphere, followed by a further heat treatment at 170°C for 2 hours. In this way, the adhesive laminate sheet 70 was laminated onto the laminate 50 (see Figure 3(iii)).

### (3) Heating Treatment

A heating treatment, simulating solder reflow, was carried out on the laminate 50 after the lamination of the adhesive laminate sheet 70. This heating treatment was carried out at 260°C for 1 minute in a nitrogen atmosphere.

### (4) Releasing First Carrier

The first carrier 52 was released from the laminate 50 together with the first intermediate layer 54 after the heating treatment (see Figure 4(iv)). That is, with the adhesive laminate sheet 70 fixed in place, by applying a force in such a direction that the first carrier 52 and the resin-containing layer 60 were separated from each other, the first carrier 52 and the first intermediate layer 54 were released.

### (5) Releasing Second Carrier,

The second carrier 72 was released from the laminate 50, from which the first carrier 52 had been released, together with the second intermediate layer 74 (see Figure 5(ix)). That is, with the resin-containing layer 60 side of the laminate 50 (the side where the first carrier 52 had been released) fixed in place, by applying a force in such a direction that the second carrier 72 and the resin-containing layer 60 were separated from each other, the second carrier 72 and the second intermediate layer 74 were released.

### (6) Removing Second Release Layer and Second Metal Layer

The second release layer 76 remaining on the laminate 50 was removed by ashing. That is, the laminate 50 was placed in an ashing chamber, oxygen gas was introduced therein, and the oxygen was then activated by plasma-generating power. As a result, carbon, which is the main component of the second release layer 76, was bonded to the activated oxygen to form carbon dioxide, and the second release layer 76 was removed as a reaction product gas. Thereafter, the second metal layer 78 exposed on the surface of the laminate 50 was removed by etching. Specifically, the Ti layer was removed by treating with a hydrogen peroxide-based alkaline etching solution at about 40°C for 1 minute, and the Cu layer was removed by treating with a sulfuric acid-hydrogen peroxide-based etching solution at about 25°C for 1 minute. In this way, the adhesive layer 80 was exposed (see Figure 6(x)).

### (7) Removing Adhesive Layer

The laminate 50, from which the second release layer 76 and the second metal layer 78 had been removed, was immersed in a resist stripping solution (ST-120 manufactured by Tokyo Ohka Kogyo Co., Ltd.) at 50°C for 3 minutes. As a result, the adhesive layer 80 exposed on the surface of the laminate 50 was swollen and dissolved (see Figure 6(xi)). In this way, it was confirmed that, according to the adhesive laminate sheet of the present invention, release and removal after use as a reinforcing sheet can be rapidly performed.

## Claims

1. An adhesive laminate sheet comprising:
a carrier;
a release layer provided on the carrier; and
an adhesive layer provided on the release layer and containing an adhesive material.

2. The adhesive laminate sheet according to claim 1, further comprising a metal layer provided between the release layer and the adhesive layer.

3. The adhesive laminate sheet according to claim 1 or 2, wherein the carrier is composed of a metal.

4. The adhesive laminate sheet according to claim 1 or 2, wherein the carrier is composed of at least one selected from the group consisting of aluminum, stainless steel, copper, titanium, nickel, and duralumin.

5. The adhesive laminate sheet according to claim 1 or 2, wherein the adhesive material is at least one selected from the group consisting of a thermosetting epoxy resin, a thermosetting polyimide resin, a photosensitive polyimide resin, an acrylic resin, and a phenolic resin.

6. The adhesive laminate sheet according to claim 1 or 2, wherein the adhesive layer has a thickness of 1 µm or more and 2000 µm or less.

7. The adhesive laminate sheet according to claim 1 or 2, wherein a ratio of a plan view area of the adhesive layer A_{A} to a plan view area of the carrier A_{C}, A_{A}/A_{C}, is 0.03 or more and 1.0 or less.

8. The adhesive laminate sheet according to claim 2, wherein the metal layer is composed of at least one metal selected from the group consisting of Ti, Cu, Al, Nb, Zr, Cr, W, Ta, Co, Ag, Ni, In, Sn, Zn, Ga, and Mo.

9. The adhesive laminate sheet according to claim 2, wherein the metal layer has a thickness of 10 nm or more and 1000 nm or less.

10. The adhesive laminate sheet according to claim 1 or 2, wherein the release layer contains carbon.

11. A laminate comprising:
the adhesive laminate sheet according to claim 1 or 2;
a resin-containing layer provided on the adhesive layer of the adhesive laminate sheet; and
an additional metal layer provided on the resin-containing layer.

12. The laminate according to claim 11, further comprising:
an additional release layer provided on the additional metal layer; and
an additional carrier provided on the additional release layer.

13. A method for manufacturing a wiring board, comprising the steps of:
providing a laminate including a first carrier, a first release layer, a first metal layer, and a resin-containing layer in this order;
laminating an adhesive laminate sheet onto the laminate, wherein the adhesive laminate sheet includes a second carrier, a second release layer, and an adhesive layer containing an adhesive material in this order, and the adhesive laminate sheet is laminated onto the laminate so that the adhesive layer comes into contact with the resin-containing layer;
releasing the first carrier from the laminate onto which the adhesive laminate sheet has been laminated via the first release layer;
releasing the second carrier from the laminate from which the first carrier has been released via the second release layer;
removing the second release layer from the laminate from which the second carrier has been released, thereby exposing the adhesive layer; and
removing the adhesive layer from the laminate from which the second release layer has been removed.

14. The method for manufacturing a wiring board according to claim 13, wherein the adhesive laminate sheet further includes a second metal layer between the second release layer and the adhesive layer.

15. The method for manufacturing a wiring board according to claim 13 or 14, wherein the resin-containing layer includes:
a first redistribution layer provided on the first metal layer;
a mold resin layer provided on the first redistribution layer; and
a second redistribution layer provided on the mold resin layer.

16. The method for manufacturing a wiring board according to claim 15, wherein the mold resin layer contains an epoxy resin and/or a phenolic resin.

17. The method for manufacturing a wiring board according to claim 13 or 14, wherein release of the first carrier is carried out by a laser lift-off method or a mechanical method.

18. The method for manufacturing a wiring board according to claim 13 or 14, further comprising the step of heating the laminate at 100°C or higher and 350°C or lower after laminating the adhesive laminate sheet onto the laminate and before releasing the second carrier.

19. The method for manufacturing a wiring board according to claim 13 or 14,
wherein the method further comprises the step of, after releasing the first carrier from the laminate and before releasing the second carrier, laminating an additional adhesive laminate sheet onto a surface of the laminate on a side where the first carrier has been released,
wherein the additional adhesive laminate sheet includes a third carrier, a third release layer, and a second adhesive layer containing an adhesive material in this order, and
wherein lamination of the additional adhesive laminate sheet onto the laminate is carried out so that the second adhesive layer comes into contact with the surface of the laminate on a side where the first carrier has been released.
